# EUROPEAN PATENT SPECIFICATION

(11) **EP 1 163 597 B1**
(45) Date of publication and mention of the grant of the patent: **02.07.2003**
(21) Application number: 00912599.8
(22) Date of filing: 13.03.2000
(51) Int. Cl.: G06F 13/38

(54) **METHOD FOR THE MANAGEMENT OF DATA RECEIVED VIA A DATA BUS, AND APPARATUS FOR CARRYING OUT THE METHOD**
VERFAHREN UM DURCH EINEN DATENBUS EMPFANGENE DATEN ZU VERWALTEN UND VORRICHTUNG ZUR DURCHFÜHRUNG DES VERFAHRENS
TECHNIQUE DE GESTION DE DONNEES RE UES VIA UNE LIAISON A HAUT DEBIT ET APPAREIL PERMETTANT DE METTRE EN OEUVRE CETTE TECHNIQUE

(30) Priority: 25.03.1999 DE 19913585
(43) Date of publication of application: 19.12.2001
(73) Proprietor: Thomson Licensing S.A., 92100 Boulogne-Billancourt (FR)
(72) Inventor: SCHWEIDLER, Siegfried, D-30989 Gehrden (DE); HEIGHWAY, Timothy, Spinney Hill, Northampton NN3 6BA (GB); GAEDKE, Klaus, D-30659 Hannover (DE)
(74) Representative: Schäferjohann, Volker Willi, Dipl.-Phys.
(86) International application number: EP0002182
(87) International publication number: WO00058844

(56) References cited:
- WO-A-98/47271
- FR-A- 2 766 938
- US-A- 5 875 313

## Description

The invention relates to a method for the management of data received via a data bus. The method can expediently be employed in particular when isochronous data packets are being received. The invention furthermore relates to an apparatus for carrying out the method. The apparatus may be, in particular, part of a bus interface for the connected data bus.

### Prior art

The invention is based on a method for the management of data packets received via the data bus of the generic type of the independent Claim 1. For quite a long time now the convergence of the product sectors of consumer electronics (hifi, video, audio) and personal computing has been trumpeted under the catchword multimedia and has actually been propelled by many manufacturers from both camps. The merging of the two product sectors means that work concerned with the subject of data exchange between the equipment of the different product sectors or else between the equipment within one product sector is becoming more and more significant. This is also apparent from the efforts for standardization with regard to this subject, which are already well advanced. Specifically, the so-called IEEE 1394 serial bus already provides an internationally standardized and very widely accepted bus for data exchange between terminals from both product groups. The precise designation of the aforementioned standard is: IEEE Standard for high performance serial bus, (IEEE) STD 1394-1995, IEEE New York, August 1996.

The invention that is to be described here is concerned with the so-called isochronous data transfer within the abovementioned bus system. In this connection, isochronous means that data to be transmitted arise regularly at a data source, the data also arising with approximately the same size each time. Examples of such data sources are video recorders or camcorders, audio devices such as CD players or DAT recorders, and also DVD players or videophone devices, etc. An international standard has been specially developed for this application of isochronous data transmission. The precise designation of this standard is: IEC International Standard 61883 "Consumer Audio/Video Equipment-Digital Interface, 1st edition 1998". The first part of this standard describes the general data packet format, the data flow management and the connection management for audiovisual data. General transmission rules for control commands are likewise defined.

A very frequent application relates to the transmission of MPEG2-coded video or audio data. The data are transported via the bus in packets, as already mentioned. In this case, the following structure is provided in the abovementioned Standard IEC 61883: the data generated in the data source are divided into so-called data source packets having a defined size. For MPEG2 video data transmission, for example, the standard stipulates that a data source packet is composed for example of 8 data blocks of identical size. In this case, the data block size can be programmed. It may be between one and 256 quadlets, where a quadlet corresponds to a combination of 4 data bytes. According to the Standard, the data source packets can be transmitted such that they are combined in a single bus packet. In this case, no addressing problem is manifested in the device that has received the data, because it is always clear that, for each new received bus packet, a completely received data source packet has arrived.

However, the abovementioned standard also certainly permits another mode, in which fewer than eight data blocks can be transmitted in a bus packet. Put in concrete terms, it is also possible to transmit so-called dummy packets which do not contain any data blocks at all. However, further possible numbers of data blocks in a bus packet of between 0 and 8 are also allowed. The invention is now concerned with the concrete realization of this more general transmission mode.

### Invention

The following problem arises in the realization of the general transmission mode. If it happens on an occasion that a bus packet contains fewer than eight data blocks of useful data, a complete data source packet can no longer be transmitted in the bus packet. Consequently, data blocks of the data source packet also follow in the next bus packet. If eight data blocks are then transmitted again e.g. in the next bus packet, the data block boundary between two data source packets is no longer synchronous with the end of the bus packet but rather lies somewhere in the bus packet. The memory management unit in the receiver device has to search for this boundary since it has to provide the information of where a data source packet starts and ends in special registers. This is necessary in order that it can make the data available to the application process after reception source packet by source packet. Thus, it is necessary to find a solution as to how the start and the end of a data source packet transmitted in fragments can subsequently be ascertained in the receiver device.

The invention achieves this object in such a way that it carries out modulo-n counting of the data blocks and signals the beginning of a new data source packet at the beginning of the respective next time interval of modulo-n counting. For the special case of the transmission of MPEG 2 source data, where the data source packet in each case comprises eight data blocks, modulo-8 counting is correspondingly carried out. In other words, the counting interval begins at the counter reading 0 and ends at the counter reading 7. Afterwards, the next counting interval then follows again, beginning with the counter reading 0.

Further improvements of the method are possible by virtue of the measures evinced in the dependent claims. Since, according to the IEEE 1394 Standard, each bus packet must be subjected to CRC checking, it is expedient to buffer-store the checking results of successive bus packets. It is ensured that the data are free from errors only when all the bus packets containing a data block of the data source packet have been able to be subjected to CRC checking without a complaint. In the event of a complaint, a CRC error signal can then be output. The entire data source packet can then not be forwarded to the application process.

Checking the completeness of the transmitted data with the aid of a reference counter reading provided in each bus packet can be done as follows: comparison counting of the received data blocks is effected and each time the specific data block with which the reference counter reading is associated is received, a comparison is made between the reference counter reading and the result of the comparison counting and an error signal is output in the event of non-correspondence. The IEC 61883 Standard stipulates that a DBC reference value which is valid for the first subsequent data block is entered in each bus packet. By counting the received data blocks and comparing the result with the received reference value, it is thus possible easily to ascertain whether e.g. a whole bus packet has not been received. The error monitoring is again improved by this measure.

The following measures, which specify the way in which the corresponding object of the invention is achieved, are advantageous for an apparatus for carrying out the method according to the invention. The apparatus firstly comprises a memory unit to which the received data are written in order. Furthermore, a memory management device is provided which prescribes, in particular, the addresses for the read-in and read-out process. What are then essential are the modulo-n counter, by which the received data blocks are counted up, and the generation of the data source packet start signal when the modulo-n counter begins a new counting interval. The data source packet start signal is forwarded to the memory management device, which can then make a corresponding entry in a special register. These measures are specified in Claim 5.

Further advantageous measures for the apparatus according to the invention are also contained in the dependent Claims 6-8.

### Drawings

Exemplary embodiments of the invention are illustrated in the drawings and are explained in more detail in the description below. In the figures:

| | |
|---|---|
| Figure 1 | shows the structure of a plurality of successive bus packets for the general transmission mode, and |
| Figure 2 | shows a block diagram of the apparatus according to the invention. |

### Exemplary embodiments of the invention

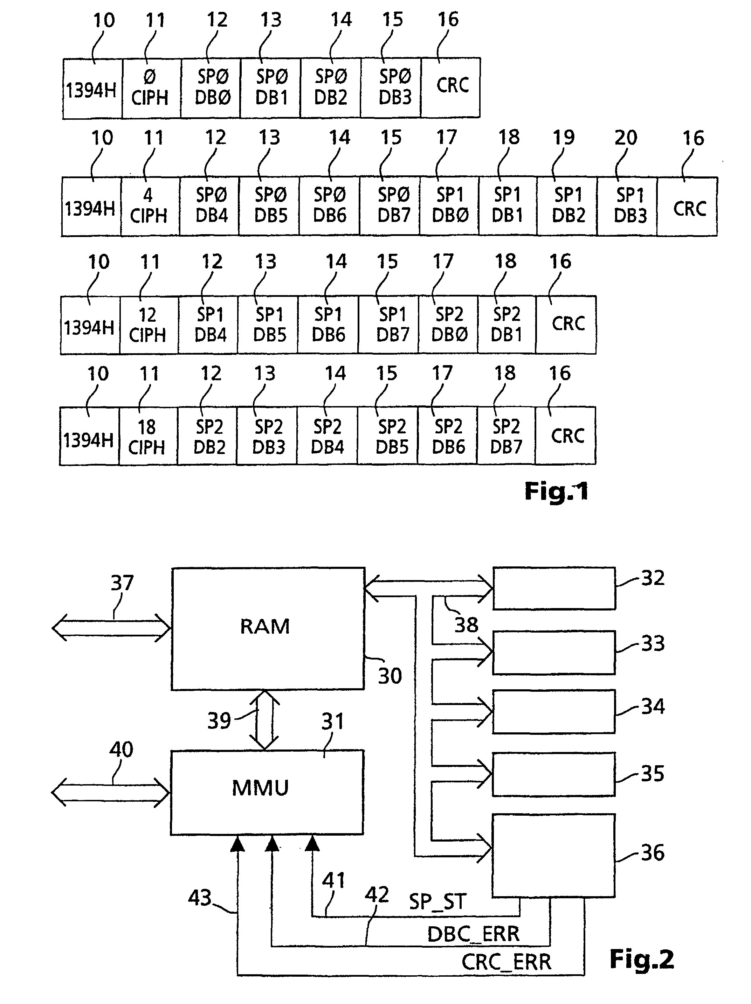

Figure 1 shows an exemplary sequence of transmitted bus packets. The first transmitted bus packet is illustrated at the top in Figure 1 and the last transmitted bus packet is correspondingly illustrated at the bottom in Figure 1. The precise structure of a bus packet for isochronous data transmission is specified in the abovementioned IEC 61883 Standard. For the disclosure of the invention, therefore, reference is also expressly made to this standard.

In Figure 1, the reference numeral 10 designates the header of the bus packet. It contains the details regarding the data field of the isochronous data packet, to be precise in a number of bytes and also further information, but this need not be discussed in any more detail below. The header 10 of the bus packet is followed by a data field. The latter extends through the areas 11-15, referring to the first bus packet illustrated. At the end of the bus packet there also follows an area 16, in which a CRC check word is stored. A so-called CIP header is always provided at the beginning of the data field of a bus packet. CIP is the abbreviation of "common isochronous packet". The CIP header contains a series of information items which describe the isochronous data transfer. Thus, e.g. an identification number SID for the data source is contained therein. Furthermore, it stipulates the size of the subsequent data blocks in the bus packet. Likewise, a detail FN (fraction number) is also contained, which specifies the number of data blocks into which a data source packet is divided. As already mentioned, there are always 8 data blocks per data source packet in the case of MPEG 2 video data. A further detail QPC (quadlet padding count) relates to how many padding quadlets are attached to the end of the data source packet in order to guarantee that the latter is divided into data blocks of the same size. Furthermore, an information item SPH (source packet header) is provided, which specifies whether a header for the data source packet is likewise also provided in the bus packet. Furthermore, a DBC value (data block counter) is also provided. This value specifies which data block is the first data block in the bus packet. Therefore, all the data blocks are consecutively numbered individually. This value practically constitutes a reference counter reading which can easily be used to check whether a bus packet has not been received. To that end, the received data blocks are all counted up in the receiver station. Each time a new bus packet is received, the DBC value contained therein is compared with the counted comparison value. Only if both values correspond have all the data blocks been received and no bus packet has been lost. Further information items in the CIP header include an FMT entry (format ID). This entry can be used to signal that the bus packet contains no data at all and is a so-called dummy packet. An FDF entry (format dependent field) may also be defined, this being mentioned only for the sake of completeness, and also an SYT entry, which comprises a time specification for the bus packet. The data blocks for the first data source packet SP0 then follow in the subsequent areas 12, 13, 14 and 15. The data blocks are individually consecutively numbered from DB0-DB3. The entry 0 in the data area 11 is intended to indicate that the DBC value for this first bus packet is set to the value 0, which is synonymous with the fact that the first data block in this bus packet has the number 0. This must, of course, also be taken into consideration for the comparison counting. Therefore, the comparison count begins at 0. The next bus packet contains a total of 8 data blocks. They reside in the data fields 12-15 and 17 to 20. The data blocks DB4 to DB7 of the data source packet SP0 are additionally contained in this second bus packet. There then follow the data blocks DB0 to DB3 of the data source packet SP1. The detail 4 in the data field 11 indicates that the 4th data block of the isochronous data transmission can be found in this bus packet. In the third bus packet, there then additionally follow in the data fields 12, 13, 14, 15, 17, 18 the outstanding data blocks DB4 to DB7 of the second data source packet and the first two data blocks of the next data source packet SP2. Thus, this bus packet contains a total of six data blocks. The detail 12 in the data field 11 again corresponds to the DBC value of this bus packet. It means that the data block that follows first in this bus packet is the twelfth data block of the isochronous transmission. In the fourth bus packet, there then additionally follow the remaining data blocks of the data source packet SP2, namely DB2 to DB7. The DBC value in the data field 11 of this bus packet is correspondingly 18.

The boundary between the data blocks of the first data source packet SP0 and the data blocks of the second data source packet SP1 is situated in the middle of the second bus packet. The boundary between the data blocks of the second bus packet SP1 and the data blocks of the third bus packet SP2 is situated in the last third of the third bus packet. These boundaries must be determined in order that the corresponding address entries can be made in the special registers of the memory management unit.

The invention affords a solution enabling the data source packet boundaries to be determined; this solution is explained in more detail below with reference to Figure 2. Figure 2 shows the components relevant to the invention. These components are parts of a data link layer circuit of an IEEE 1394 bus interface. The reference number 30) designates a memory unit which is provided below for receiving and buffer-storing data. It may be part of a larger memory unit, just a specific area within the larger memory simply being allocated for this purpose. The received data pass via the bus 37 to the memory unit 30. The data are buffer-stored in the memory unit 30 until they are forwarded to the application unit. In this case, the data are output likewise via the bus 37 to the application unit, which is not specifically illustrated in Figure 2. The following units also have access to the memory unit 30: CRC checking unit 32, modulo-8 counter 33, DB counter 34, data counter 35 and evaluation logic unit 36. All of these units are connected to one another via an internal bus 38 and are likewise connected to the memory unit 39 as well. The memory management unit 31 is also a further separate unit. The said memory management unit likewise has access to the memory unit 30 via the internal bus 38. Therefore, it also serves as the bus master for the internal bus 38 and allocates it to the individual connected units. It is connected to the memory unit 30 via a separate bus 39. Moreover, a bus 40 is connected to the memory management unit 31, via which bus control data are exchanged with the external application unit. Separate control lines additionally lead from the evaluation unit 36 to the memory management unit 31. These lines are firstly a line 41 via which a data source packet start signal SP_ST is transmitted, secondly a line 42 via which an error signal DBC_ERR is output, and thirdly a line 43 via which a CRC error signal CRC_ERR is output.

In order now to find the data source packet boundaries, the apparatus described operates as follows: the individual data blocks, which after all have a constant size, are counted in the modulo-8 counter 31. If this counter starts to count with the counter reading 0, it will reach its highest value, referring to the example of Figure 1, at the last data block DB7 of the data source packet SP0 and then start at 0 again after the last data block DB7 has been completely written to the memory. It then outputs the data source packet start signal SP_ST to the memory management unit 31, which then transfers the address that is now valid for the new data into the corresponding special register for the beginning of the next data packet. Since the data blocks all have the same size, there is no need to provide a special register in which the end address of the last data packet of a data source packet has to be entered.

Since the modulo-8 counter sets the counter reading to 0 again and then continues to count, it will have reached the counter reading 7 precisely again after the data block DB7 of the data source packet SP1 has been written in. It will therefore output a data source packet start signal which is forwarded via the evaluation unit 36 to the memory management unit 31 and causes the latter to store the memory address in the further special register. The counting is begun at 0 again and a data source packet start signal SP_ST would be generated anew after the reception of the data block DB7 of the data source packet SP2.

To ensure, however, that the data source packet start signals that are generated actually lead to the transfer of the corresponding address in the special registers, it is a precondition in this exemplary embodiment that error signals are not simultaneously present on the lines 42, 43. This is because otherwise the received data have been detected as containing errors and they are no longer allowed to be passed on to the application unit. Each received bus packet is checked with regard to freedom from errors in the CRC checking unit 32. Since the CRC check word at the end of each bus packet in the data field 16 only relates to all the data in this bus packet, the fact that a data source packet is free from errors can only be ascertained such that the CRC checking results of the individual bus packets are collected and are jointly evaluated each time the data source packet start signal is generated. If one of the CRC check words of the bus packets that are considered together indicates an error, the error signal CRC_ERR is output via the line 43. For example, after the generation of the data source packet start signal after the reception of the data block DB7 of the first data source packet SP0, the two CRC checking results for the first received bus packet and also for the second received bus packet must indicate freedom from errors in order that no error signal is output via the line 43. As already mentioned, the CRC checking of the individual bus packets is done in the CRC checking unit 32. The collection of the individual checking results is then done in the evaluation unit 36. The same is true with regard to the generation of the error signal CRC_ERR when one of the checking results concerning a data source packet indicates an error.

The DB counter 34 counts up all the received data blocks. According to the IEC 61883 Standard, this counter is an 8-bit counter. If all the bus packets are received properly, this counter will respectively have the counter readings 4, 12 and 18 after the reception of the first, second and third data packets. These values are indeed also entered as reference values in the data fields 11 of the bus packets 2, 3 and 4. However, should the counter not have the counter reading as respectively specified in the data field 11, the evaluation unit 36 will generate the error signal DBC_ERR already mentioned.

The data counter 35 operates as follows: it counts the data in units of bytes. In the IEC 61883 Standard, the data block size is specified in units of quadlets. The data block size can be programmed; to be precise all values between 1 and 256 quadlets are possible. The stipulated value is contained in the CIP header CIPH. This value is evaluated and is then available in the evaluation logic unit 36. The data counter 35 is then set in such a way that, when the end of a data block is reached, the said data counter generates a data block counting pulse and outputs it to the data block counter 34.

Various adaptations and modifications of the exemplary embodiments described are possible. The structure with the various internal bus lines and bus lines provided for the external components, as described, may be chosen differently. Parts of the apparatus explained may also be realized by software. The invention is not restricted to use with the IEEE 1394 bus mentioned. It can also be used for other wire-based bus systems or else for wire-free bus systems.

## Claims

1. Method for the management of data received via a data bus, the data being transmitted in bus packets having a variable length, the data being divided into data blocks (DB0-DB7) having a defined length, a combination of a defined number n of data blocks (DB0-DB7) forming a data source packet (SP0-SP2), section-by-section transmission of the data source packet (SP0-SP2) within the framework of data blocks being permitted, **characterized in that** modulo-n counting of the data blocks (DB0-DB7) is carried out in order to determine the data source packet boundaries, and **in that** the beginning of a new data source packet (SP1, SP2) is signalled to a memory management device (31) at the beginning of the next counting interval.

2. Method according to Claim 1, in which each bus packet is subjected to CRC checking and the checking results are buffer-stored in order to be able to ascertain whether a data source packet (SP0-SP2) transmitted in two or more bus packets has been transmitted without any errors.

3. Method according to Claim 1 or 2, in which a reference counter reading is transmitted in each bus packet in order to check the completeness of the transmitted data, and in which comparison counting of the received data blocks (DB0-DB7) is effected and, when the data block associated with the reference counter reading is received, the result of the comparison counting is compared with the reference counter reading and an error signal (DBC_ERR) is output in the event of non-correspondence.

4. Method according to one of the preceding claims, in which the defined number n of data blocks (DB0-DB7) of a data source packet (SP0-SP2) corresponds to the number 8 and the modulo-n counting is correspondingly modulo-8 counting.

5. Apparatus for carrying out the method according to one of the preceding claims, having a memory unit (30) to which the received data are written in order, and having a memory management device (31), **characterized in that** a modulo-n counter (33) is provided, which counts the received data blocks (DB0-DB7) and outputs a data source packet start signal (SP_ST) to the memory management device (31) at the beginning of the next counting interval.

6. Apparatus according to Claim 5, which furthermore has a CRC checking unit (32), by means of which the data in the received bus packets are checked with regard to freedom from errors, where the checking results of a plurality of successive bus packets are buffer-stored and combined if the data source packet start signal (SP_ST) has been identified, and where the CRC checking unit (32) outputs an error signal (CRC_ERR) if one of the combined checking results includes an identified error.

7. Apparatus according to Claim 5 or 6, which furthermore has a data block reference counter (34), which effects the comparison counting of the received data blocks (DB0-DB7), and where comparison means are provided which compare the counter reading of the data block reference counter (34) with the received reference counter reading of the bus packet and output an error signal (DBC_ERR) in the event of non-correspondence.

8. Apparatus according to one of claims 5 to 7, which furthermore has a data counter (35), by which the data are counted in particular in units of bytes and which outputs a data block counting signal if the number of data that have been counted are as many as are defined as belonging to a data block (DB0-DB7).

9. Apparatus according to one of claims 5 to 8, where the data bus is designed according to the IEEE 1394 standard and the apparatus is part of a data link layer module in the interface for this data bus.

## Patentansprüche

1. Verfahren zum Verwalten von über einen Datenbus empfangenen Daten, wobei die Daten in Buspaketen mit variabler Länge übertragen werden, wobei die Daten in Datenblöcke (DB0-DB7) definierter Länge eingeteilt sind, wobei eine Zusammenfassung von einer definierten Anzahl n von Datenblöcken (DB0-DB7) ein Datenquellpaket (SP0-SP2) bildet, wobei eine abschnittsweise Übertragung der Datenquellpakete (SP0-SP2) im Rahmen von Datenblöcken zugelassen ist, **dadurch gekennzeichnet, daß** zur Bestimmung der Datenquellpaketgrenzen eine Modulo-n-Zählung der Datenblöcke (DB0-DB7) durchgeführt wird und daß der Beginn eines neuen Datenquellpaketes (SP1, SP2) bei Beginn des nächsten Zählintervalls einer Speicherverwaltungseinrichtung (31) signalisiert wird.

2. Verfahren nach Anspruch 1, wobei jedes Buspaket einer CRC-Überprüfung unterzogen wird und die Prüfergebnisse zwischengespeichert werden um feststellen zu können ob ein in zwei oder mehreren Buspaketen übertragenes Datenquellpaket (SP0-SP2) fehlerfrei übertragen wurde.

3. Verfahren nach Anspruch 1 oder 2, wobei zur Überprüfung der Vollständigkeit der übertragenen Daten in jedem Buspaket ein Referenzzählerstand übertragen wird und wobei eine Vergleichszählung der empfangenen Datenblöcke (DB0-DB7) erfolgt und bei Empfang des zu dem Referenzzählerstand gehörenden Datenblocks das Ergebnis der Vergleichszählung mit dem Referenzzählerstand verglichen wird und bei Nicht-Übereinstimmung ein Fehlersignal (DBC-ERR) ausgegeben wird.

4. Verfahren nach einem der vorhergehenden Ansprüche, wobei die definierte Anzahl n von Datenblöcken (DB0-DB7) eines Datenquellpaketes (SP0-SP2) der Anzahl 8 entspricht und dementsprechend die Modulo-n-Zählung eine Modulo-8-Zählung ist.

5. Vorrichtung zur Durchführung des Verfahrens nach einem der vorhergehenden Ansprüche mit einer Speichereinheit (30) in die die empfangenen Daten der Reihe nach eingeschrieben werden, und mit einer Speicherverwaltungseinrichtung (31), **dadurch gekennzeichnet, daß** ein Modulo-n-Zähler (33) vorgesehen ist, der die empfangenen Datenblöcke (DB0-DB7) zählt und bei Beginn des nächsten Zählintervalls ein Datenquellpaketstartsignal (SP_ST) an die Speicherverwaltungseinrichtung (31) abgibt.

6. Vorrichtung nach Anspruch 5, die weiterhin eine CRC-Prüfeinheit (32) aufweist, mittels derer die Daten in den empfangenen Buspaketen auf Fehlerfreiheit überprüft werden, wobei die Prüfergebnisse mehrerer aufeinanderfolgender Buspakete zwischengespeichert werden und zusammengefaßt werden, wenn das Datenquellpaketstartsignal (SP_ST) erkannt worden ist und wobei die CRC-Prüfeinheit (32) ein Fehlersignal (CRC_ERR) ausgibt, wenn eines der zusammengefaßten Prüfergebnisse einen erkannten Fehler ausweist.

7. Vorrichtung nach Anspruch 5 oder 6, die weiterhin einen Datenblockreferenzzähler (34) aufweist, mit dem die Vergleichszählung der empfangenen Datenblöcke (DB0-DB7) erfolgt und wobei Vergleichsmittel vorgesehen sind, die den Zählerstand des Datenblockreferenzzählers (34) mit dem empfangenen Referenzzählerstand des Buspaketes vergleichen und bei Nicht-Übereinstimmung ein Fehlersignal (DBC-ERR) ausgeben.

8. Vorrichtung nach einem der Ansprüche 5 bis 7, die weiterhin einen Datenzähler (35) aufweist mit dem die Daten insbesondere in Einheiten von Bytes gezählt werden und der ein Datenblockzählsignal ausgibt, wenn soviel Daten gezählt worden sind, wie definierterweise zu einem Datenblock (DB0-DB7) gehören.

9. Vorrichtung nach einem der Ansprüche 5 bis 8, wobei der Datenbus nach dem IEEE 1394-Standard ausgelegt ist und die Vorrichtung Teil eines Data-Link-Layer-Bausteins in der Busschnittstelle für diesen Datenbus ist.

## Revendications

1. Technique de gestion de données reçues via un bus de données, les données étant transmises en paquets de bus présentant une longueur variable, les données étant divisées en blocs de données (DB0-DB7) présentant une longueur définie, une combinaison d'un nombre n défini de blocs de données (DB0-DB7) formant un paquet de sources de données (SP0-SP2), la transmission section par section du paquet de sources de données (SP0-SP2) au sein de la structure de blocs de données autorisés, **caractérisée en ce que** le comptage modulo-n des blocs de données (DB0-DB7) est effectué afin de déterminer les limites des paquets de sources de données, et **en ce que** le début d'un nouveau paquet de sources de données (SP1, SP2) est signalé à un dispositif de gestion de mémoire (31) au début de l'intervalle de comptage suivant.

2. Technique conforme à la Revendication 1, dans laquelle chaque paquet de bus fait l'objet d'un contrôle CRC et les résultats du contrôle sont stockés en mémoire tampon en vue de déterminer si un paquet de sources de données (SP0-SP2) transmis en deux paquets de bus ou plus a été transmis sans erreur.

3. Technique conforme à la Revendication 1 ou 2, dans laquelle une valeur de compteur de référence est transmise à chaque paquet de bus afin de vérifier l'exhaustivité des données transmises, et dans laquelle le comptage de comparaison des blocs de données reçus (DB0-DB7) est effectué et, lorsque le bloc de données associé à la valeur de compteur de référence est reçu, le résultat du comptage de comparaison est comparé à la valeur de compteur de référence et un signal d'erreur (DBC_ERR) est émis en cas de non-correspondance.

4. Technique conforme à l'une des revendications précédentes, dans laquelle le nombre n défini de blocs de données (DB0-DB7) d'un paquet de sources de données (SP0-SP2) correspond au nombre 8 et le comptage modulo-n est en conséquence un comptage modulo-8.

5. Appareil permettant de mettre en oeuvre cette technique conformément à l'une des revendications précédentes, comportant une unité de mémoire (30) dans laquelle les données reçues sont écrites dans l'ordre, et comportant un dispositif de gestion de mémoire (31), **caractérisé en ce qu'**un compteur modulo-n (33) est fourni, qui compte les blocs de données reçus (DB0-DB7) et émet un signal de début des paquets de sources de données (SP_ST) vers le dispositif de gestion de mémoire (31) au début de l'intervalle de comptage suivant.

6. Appareil conforme à la Revendication 5, qui présente également une unité de contrôle CRC (32), au moyen de laquelle les données des paquets de bus reçus sont vérifiées en vue de la détection d'éventuelles erreurs, où les résultats du contrôle de plusieurs paquets de bus successifs sont stockés en mémoire tampon et combinés si le signal de début des paquets de sources de données (SP_ST) a été identifié, et où l'unité de contrôle CRC (32) émet un signal d'erreur (CRC_ERR) si l'un des résultats de contrôle combinés contient une erreur identifiée.

7. Appareil conforme à la Revendication 5 ou 6, qui présente également un compteur de référence de blocs de données (34) qui effectue le comptage de comparaison des blocs de données reçus (DB0-DB7) et qui inclut un système de comparaison qui compare la valeur de compteur du compteur de référence de blocs de données (34) à la valeur de compteur de référence du paquet de bus reçue et émet un signal d'erreur (DBC_ERR) en cas de non-correspondance.

8. Appareil conforme à l'une des Revendications 5 à 7, qui présente également un compteur de données (35), par lequel les données sont comptées particulièrement en unités d'octets et qui émet un signal de comptage de blocs de données si le nombre de données ayant été comptées est égal au nombre défini de données appartenant à un bloc de données (DB0-DB7)

9. Appareil conforme à l'une des Revendications 5 à 8, où le bus de données est créé conformément à la norme IEEE 1394 et l'appareil fait partie d'un module de couche de liaison de données dans l'interface de ce bus de données.
